Europäisches Patentamt

(19) European Patent Office

Office européen des brevets

(11) Publication number : **0 303 813 B1**

# EUROPEAN PATENT SPECIFICATION

(12)

(45) Date of publication of patent specification :
**12.10.94 Bulletin 94/41**

(51) Int. Cl.[5] : **H01L 39/12,** H01L 39/24, H01L 39/14

(21) Application number : **88110699.1**

(22) Date of filing : **05.07.88**

(54) **High critical current superconductors.**

(43) Date of publication of application :
**22.02.89 Bulletin 89/08**

(45) Publication of the grant of the patent :
**12.10.94 Bulletin 94/41**

(84) Designated Contracting States :
**DE FR GB**

(56) References cited :
**NTIS TECH NOTES, no. 3-H, March 1986,
SPRINGFIELD, VA, US, p. 319 ; E.W. COL-
LINGS : "Paramagnetic precipitates may
raise supercurrent"
JAPANESE JOURNAL OF APPLIED PHYSICS,
SUPPLEMENTS, vol. 26, no. 26-3, 1987, TO-
KYO, JP, pp. 2053-2058 ; A.M. CAMPBELL :
"Pinning and critical currents in type II super-
conductors"**

(56) References cited :
**PHYSICAL REVIEW LETTERS, vol. 58, no. 18, 4
May 1987, NEW YORK, US, pp. 1891-1894 ; P.H.
HOR et al. : "Superconductivity above 90K in
the square-planar compound system
ABa2Cu3O6+x with A=Y, La, Nd, Sm, Eu, Gd,
Ho, Er, and Lu"
APPL. PHYS. LETT. 52(17) 1988, pp. 1447-1448;
P.Y.P.S.S.Sastry et al.
PHYS. REV. LETT. 58(16) 1987, pp. 1676-1679;
R.J. Cava et al.**

(73) Proprietor : **International Business Machines
Corporation
Old Orchard Road
Armonk, N.Y. 10504 (US)**

(72) Inventor : **Chaudhari, Praveen
416 Long Hill Road
E., Briarcliff Manor, N.Y. 10510 (US)**

(74) Representative : **Rudack, Günter O., Dipl.-Ing.
IBM Corporation
Säumerstrasse 4
CH-8803 Rüschlikon (CH)**

EP 0 303 813 B1

## Description

This invention relates to improved superconducting materials exhibiting high critical currents, and more specifically to improved superconducting materials and techniques for providing high critical currents in type II superconductors.

Superconductivity is a phenomenon that has been known in many materials, and traces back to 1911 when it was first discovered. It is generally characterized by the loss of electrical resistance of a material at a well defined temperature, as well as the ability of a material, when in a superconducting state, to expel an applied magnetic field. Superconductivity occurs in many materials, including about a quarter of the elements of the periodic table and over 1000 alloys and other multi-component systems. Generally, superconductivity is considered to be a property of the metallic state of the material since all known superconductors are metallic under the conditions that cause them to be superconducting. A few normally non-metallic materials, for example, become superconducting under very high pressure, wherein the pressure converts them to metals before they exhibit superconducting behavior.

As noted, many types of superconducting materials are known. The advantages of different materials relative to one another often depend on their superconducting transition temperature $T_c$, which is often called the critical temperature. It is the temperature above which superconductivity will not exist. Until recently, the material exhibiting the highest superconducting transition temperature was $Nb_3Ge$ which has a $T_c$ of about 23 K at ambient pressure.

Recently, the remarkable discovery by J.G. Bednorz and K.A. Müller, reported in Z. Phys. B.- Condensed Matter 64 (1986) p. 189, and Europhysics Letters 3, 379 (1987) completely changed the direction and importance of this technology. The discovery of Bednorz and Müller was that certain metallic oxides can exhibit superconducting transition temperatures considerably in excess of 23 K. These materials are often termed "high-$T_c$ superconductors".

Since these initial discoveries of Bednorz and Müller, a vast amount of research and development has been undertaken around the world to further study these types of superconducting materials in order to extend even further the temperature range over which they are superconducting, as well as to understand the basic mechanisms for superconductivity in this class of materials.

Bednorz and Müller first showed superconducting behavior in mixed copper oxides, typically including rare earth and/or rate earth-like elements and alkaline earth elements, for example La, Ba, Sr, etc., and having a perovskite-like structure. After the first reports of Bednorz and Müller, other researchers showed that the application of pressure can increase the transition temperature and that, additionally, in the Y-Ba-Cu-O systems, transition temperatures as high as 100 K could be obtained (cf., for example, M.K. Wu et al., Phys. Rev. Lett., 58 (1987) 908). Many publications in technical journals around the world have subsequently appeared addressing various aspects of superconductivity in these materials.

As noted in a paper by P. Chaudhari et al., published in the Physical Review Letters 58, p. 2684, June 1987, and entitled "Critical Current Measurements in Epitaxial Films of $YBa_2Cu_3O_{7-x}$ Compounds", one of the disadvantages often cited about this class of superconducting materials has been their small critical current. In fact, prior to the work of P. Chaudhari et al. reported in this Physical Review Letters article, the highest reported value of the critical current in this new class of materials was very small relative to that in the more familiar metallic alloys. The highest previously published value at 77 K was approximately $10^3 A/cm^2$. Since the range of potential utility of these materials is determined by the critical current, this problem remained as a formidable obstacle to the application of these materials prior to the aforementioned contribution of Chaudhari et al. In their Physical Review Letters article, they described epitaxial superconducting films of these materials in which the critical current at 77 K was in excess of $10^5 A/cm^2$. Thus, their work demonstrated for the first time that these materials could exhibit critical currents sufficiently high to make them valuable in many types of applications.

As is well known, the members of this class of superconducting metal oxides belong to the "type II superconductors" in which the presence of a superconducting current establishes trapped magnetic flux and circulating currents in the superconductor, leading to the presence of magnetic vortices therein. These vortices are known to impede the passage of superconducting current through a type II superconductor, as they limit the maximum amount of supercurrent, termed the critical current, which can be passed through the material without its losing its superconducting state.

In order to maximize the critical current, these vortices have to be printed, rather than being allowed to move in the superconductor. This can be done by introducing particles and defects into the superconductor to attract the vortices and hold them in particular locations. For example, such defects could include structural arrangements, such as dislocations or vacancies which tend to pin the vortices. Also, impurity atoms can be added to the superconductor to create localized sites where the superconductivity is lost or at least where the superconductivity exists over a more narrow temperature range. Such impurity sites, while affecting the temperature dependence of superconductivity, can pin the vortices to allow higher critical currents. As is known in the art, however, the use of such impurities and the effect on the superconducting properties of the material must be balanced against the possible increase in value of critical current through the superconducting material. Such design considerations have been used in the past to design, for example, high-field superconducting magnets. In magnet wire material, such as NbTe, impurities are used to create defects in the superconducting material which will pin the vortices, although it is recognized that these impurities will also tend to destroy superconductivity. Since these materials operate at liquid helium temperatures, and since the critical temperatures of such alloys are close to about 20 K, the loss of some superconductivity can be tolerated if the critical currents carried by the wires are increased.

In the practice of the present invention, an improved technique has been developed for pinning the magnetic vortices that limit critical currents in this class of superconductors. Further, this invention can be applied not only to the high-critical-temperature superconductors of the type first described by Bednorz and Müller, but also to other type II superconductors. Specifically, the teachings of this invention can be applied to any superconductor in which critical currents are limited by vortices, where the superconductor is characterized by a coherence length (i.e. the distance in the superconductor over which the superconductivity extends) that is sufficiently short. In the practice of this invention the coherence length in the superconductor must be of the order of the atomic dimensions of the superconductor.

Broadly, the technique and materials of the present invention utilize magnetic pinning of the vortices in these superconductors. The most direct way to accomplish magnetic pinning is to introduce atoms into the superconductor having magnetic moments associated with them that interact with the magnetic fields associated with the vortices in order to create an energy minimum for the vortices, thus pinning the vortices at the locations occupied by the atoms introduced into the superconductor. As an example of atoms that can be introduced to provide pinning, magnetic rare earth atoms are particularly suitable for use in metallic oxide superconductors of the type first described by Bednorz and Müller.

It is acknowledged that magnetic elements have been introduced into high-$T_c$ superconducting oxides. For example, reference is made to P.H. Hor et al., Phys. Rev. Lett. 58, p. 1891 (1987) who reported on the superconductor $GdBa_2Cu_3O_x$. However, in such material, the critical current $I_c$ will be approximately the same as the critical current of the superconductor $YBa_2Cu_3O_x$. Thus, the presence of the magnetic Gd atoms in place of all the Y atoms does not provide substantial pinning of the flux vortices and has, therefore, not enhanced the critical current. The paper by P.V.P.S.S. Sastry et al., "Enhancement of transport critical current density by Gd substitution in $YBa_2Cu_3O_7$", Appl. Phys. Lett. 52, No. 17, pp. 1447/8 (1988), discusses the entire substitution of Y by Gd, with a current density $J_c$ of only 90 A/cm², and a partial substitution in amounts smaller than 0,5 at.%, yielding an increase of the current density to $J_c$ to just 400 A/cm². No effort is reported, however, to optimize the Gd substitution so as to arrive at $J_c$ values that really matter, this because the role of the gadolinium as a means for pinning flux vortices was not understood but interpreted as a "scavenger of insulating phases".

To date, it is believed that no one has demonstrated magnetic pinning in these high-$T_c$ superconducting oxides, nor has anyone demonstrated magnetic pinning in other type II superconductors. In the course of applicant's work, it has been discovered how magnetic pinning can be used to provide high critical currents in these high-$T_c$ metallic oxide superconductors, as well as in previously known non-oxide type II superconductors, if these non-oxide superconductors have sufficiently small coherence lengths.

Accordingly, it is a primary object of the present invention to provide superconducting materials in which magnetic pinning is utilized to enhance the critical current in these materials.

It is another object of the present invention to provide improved type II superconductors having small coherence lengths.

It is another object of this invention to provide a technique for increasing the critical current available in all type II superconductors.

It is another object of this invention to alter the composition of high-$T_c$ metallic oxide superconductors in a manner to increase their current-carrying ability without adversely affecting the temperature range over which they remain superconducting.

It is a further object of this invention to enhance the current-carrying capabilities of metallic oxide superconductors of the type characterized by critical temperatures in excess of 23 K, and specifically to provide such materials having critical currents in excess of $10^4$ A/cm² at 77 K.

This invention broadly relates to superconducting materials having enhanced critical current values, where the critical currents are high because magnetic field vortices in the superconductors are effectively pinned by a magnetic pinning technique. This is achieved by the introduction of atoms into the superconducting material where the atoms have magnetic moments associated with them which serve to pin the magnetic flux vortices in the superconductor. However, this invention is more than the inclusion of atoms having a magnetic moment associated therewith; instead, the invention is directed to the specialized use of these atoms to provide pinning of many of the magnetic flux vortices. Further, and of critical importance is the fact that the atoms providing the magnetic pinning must be present in the superconductor in a compositionally random distribution.

If the magnetic atoms occur with compositional ordering in the superconductor, the flux vortices will not be pinned in a manner to yield high critical currents. This will be more apparent in the detailed description of the preferred embodiments, but as an example it is sufficient to state that an optimal amount of the pinning atoms appears to be about 50% replacement for the rare earth or near rare earth elements in the well known high-$T_c$ metallic oxide superconductors. Thus, if all of the Y atoms in the compound $YBa_2Cu_3O_x$ are totally replaced by atoms having a magnetic moment, substantial flux vortex pinning will not occur and the critical current will not be substantially enhanced. In this latter situation, the magnetic atoms will be ordered in the superconducting lattice, as it will be predictable what atom will be at all Y sites in the lattice and, therefore, there will be no compositional randomness.

The atoms that can be included in the superconducting composition to provide magnetic pinning of flux vortices include any atoms which have a magnetic moment associated therewith. However, it has been found that atoms having a large magnetic moment generally provide superconductors with enhanced critical current behavior even as the temperature of the material is raised. In the case of high-$T_c$ metallic oxide superconductors of the type generally including a rare earth or rare earth-like element, an alkaline earth element, copper, and oxygen; suitable substituent atoms providing a magnetic moment for flux pinning include magnetic rare earth elements such as Yb, Er, Gd, Dy, Tb, etc. Other magnetic atoms include $Cu^{2+}$ and $Ti^{2+}$, as well as Fe, Co, and Ni, although the latter three elements are less favorable as they are more apt to impair superconductivity in these high-$T_c$ metallic oxides.

For high-$T_c$ metallic oxide superconductors, the site in which the magnetic moment atom resides is not critical, as long as the superconducting properties are not adversely affected for the application for which the superconductor is to be utilized. Thus, these magnetic atoms can reside on the rare earth or alkaline earth sites, as well as on some of the copper sites as long as a large number of the copper sites responsible for superconductivity are not adversely affected. Expressions will be presented for the numbers of magnetic elements required to provide substantial flux pinning and for the provision of a suitably random compositional distribution of these magnetic atoms.

Although the invention has particular utility for use in high-$T_c$ metallic oxide superconductors, it can also be applied to any type II superconductor exhibiting a coherence length that is sufficiently small. In such materials, large local magnetic fields will be produced in the vortices, and the present invention can be used to pin these vortices. Thus, it is applicable to type II superconductors having coherence lengths of the order of the unit cell in the superconductor which could be approximately 0,3 to 3 nm in most superconductors.

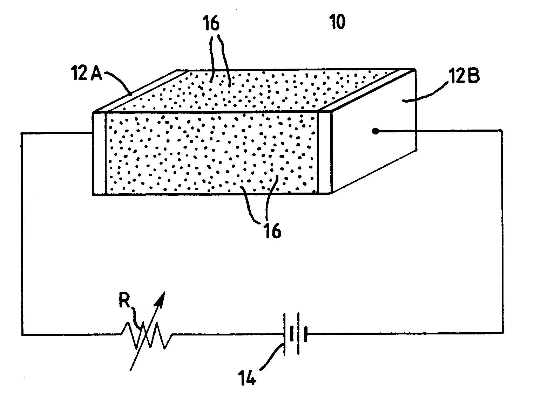

Details of embodiments of the invention will become apparent from the following more particular description and with reference to the attached drawing which illustrates a superconducting material, which could be a bulk or film material, having means for producing a supercurrent therein, and shows magnetic flux vortices that are pinned by the compositionally random distribution of magnetic atoms in the superconductor in accordance with the principles of the present invention.

This invention utilizes magnetic pinning of flux vortices in superconductors in order to enhance the critical current capabilities of the superconductors. In a particular embodiment, it can be applied to high-$T_c$ oxide superconductors. In these materials, atoms having a magnetic moment can be present without adversely affecting the superconducting properties of the material, as is known. In particular, the magnetic atoms can be present on sites which are not responsible for the superconducting properties of the material and, therefore, will not destroy the superconductivity. In the practice of the present invention, magnetic atoms are included in these high-$T_c$ superconducting materials in such a manner that substantial numbers of magnetic flux vortices are pinned so that the critical current of the material is enhanced. As will be seen, certain criticalities exist with respect to the inclusion of these magnetic atoms; for example, if they are not present in a sufficient amount or are present in an amount such as a 100% replacement of other atoms in the superconducting material, flux pinning suitable to provide high critical currents will not be obtained. Further, the sites on which the magnetic atoms reside must be compositionally random, i.e., it must not be predictable whether a magnetic atom is at a particular site. Thus, there are criticalities which must be observed in order to sufficiently pin the flux vortices to provide enhancement of the critical current.

It is generally known that magnetic flux vortices in type II superconductors can move in these materials and that they move generally at right angles to the direction of supercurrent through the materials. When they are pinned by the inclusion of magnetic atoms in accordance with the present invention, there will be an interaction between the magnetic moment of the atom and the magnetic field associated with the vortex. When these magnetic fields are aligned, the vortex will reside in an energy minimum and will therefore be pinned.

In turn, the pinning of these vortices allows the flow of maximum supercurrents in the material. Magnetic atoms will pin vortices where the vortices can be closely spaced, such as approximately 100 nanometers (or less) apart.

It has been found that magnetic atoms can be used to provide substantial vortex pinning without adversely affecting the superconducting properties of the high-$T_c$ materials. Very large pinning forces on the vortices can be provided by these magnetic atoms, but the magnetic atoms must be distributed in a compositionally random fashion in the superconductor in order to provide enhancement of the critical current. They should not be included in the superconductor in a manner in which they will reside in a compositionally ordered arrangement in the lattice of the host superconductor.

In the case of a high-$T_c$ oxide superconductor including a rare earth element, an alkaline earth element, copper, and oxygen, the magnetic atoms can reside on the rare earth sites, the alkaline earth sites, or even the copper sites. However, some of the copper sites are responsible for the high-$T_c$ superconductivity in these materials and, if sufficient amounts of the magnetic atoms reside on the copper sites responsible for superconductivity, the superconductivity of the material will be adversely affected. However, if the magnetic atoms reside on the rare earth sites, alkaline earth sites, or on the copper sites which are not responsible for superconductivity, substantial flux pinning can occur without adversely affecting the superconducting properties of the material.

The inclusion of these magnetic atoms to enhance critical current can be applied to any of these high-$T_c$ superconductors, whether the superconductors are fabricated in bulk or film form and regardless of the geometry of the superconductor (wire, plate, etc.). Further, the superconductors can be either single crystals or polycrystalline material. The magnetic atoms are generally included during the fabrication process to produce the superconductor, in a manner to be described more fully hereinafter. Such techniques are well known in the art.

For high-$T_c$ oxide superconductors, it has been found that the inclusion of magnetic atoms in sufficient amounts will lead to an appropriately compositionally random distribution of these magnetic atoms which in turn will provide substantial flux pinning (i.e. sufficient pinning to increase $I_c$). This occurs whether the magnetic atoms reside on the rare earth sites, alkaline earth sites, or even on the copper sites of these materials. The site on which the magnetic atom resides will in turn determine the valence of the magnetic atom in the material. For example, when Ti is included as a pinning atom, Ti will have a 2+ valence if it resides on the copper or alkaline earth site; it will have a 3+ valence if it resides on the rare earth site. Other representative atoms exhibiting a magnetic moment and being suitable for inclusion in these high-$T_c$ superconductors to effect vortex pinning include the magnetic rare earths such as Gd, Tb, Yb, Dy, Er, La, Eu, Lu, etc. For some of these elements, the site which they are to occupy becomes critical. For example, in the case of Eu, Lu, and La, these atoms will have a $^{3+}$ valence if they replace an element such as Y in the rare earth site. When they have $^{3+}$ valence, the magnetic moment associated with these three elements is zero. This means that when they are in the rare earth sites, they will not be useful to pin magnetic flux vortices. Also, if any of the rare-earth magnetic atoms or other magnetic atoms have their moments aligned by crystal fields rather than by the magnetic field of the vortex, they will not be effective in pinning vortices.

As noted earlier, magnetic elements such as Fe, Co, and Ni can be used, although these are generally less favorable atoms for this purpose. In particular, atoms of these three elements generally tend to reside on the copper sites in these high-$T_c$ oxide superconductors and, therefore, tend to more directly affect the superconductivity of the material. Since it is generally difficult to control the site to which these three elements adhere, and since they tend to reside on the copper sites, their presence will more greatly disturb the superconducting properties of the material. Thus, they must be present in generally smaller amounts and, when so present, will not provide the degree of flux pinning required to have the highest possible critical currents.

It is also possible to utilize $Cu^{2+}$ to provide magnetic pinning in these materials. In these high-$T_c$ oxide superconductors, generally about 1 atom per two unit cells is $Cu^{3+}$, the remainder being $Cu^{2+}$. The $Cu^{2+}$ and $Cu^{3+}$ are distributed randomly on the Cu sites, and the $Cu^{2+}$ can be increased in order to provide some flux pinning. However, other atoms will provide a larger magnetic moment than $Cu^{2+}$, and are generally more effective for flux pinning.

As noted, the locations of the magnetic pinning atoms must be random in the superconducting lattice. If they are ordered, the vortices will not be as effectively pinned and, if completely ordered, no pinning will result. Additionally, it has been discovered that atoms providing a large magnetic moment, in addition to providing stronger pinning forces, also help the temperature dependence of the critical current in the superconductor. For example, if the critical current is plotted against temperature in a high-$T_c$ oxide superconductor including a compositionally random distribution of magnetic pinning atoms, it will be found that the enhancement of the critical current will extend over a wider temperature range when the magnetic atoms have large magnetic moments. Thus, the inclusion of an element such as Gd, which has a larger magnetic moment per atom than, for

instance, $Cu^{2+}$ will provide enhancement of the critical current over a larger temperature range than will $Cu^{2+}$.

While the invention has particular applicability to high-$T_c$ oxide superconductors, it is also applicable in principle to any type II superconductor having a small coherence length. The coherence length is a measure of the range over which superconductivity extends in a material, and is generally large in most non-oxide type II superconductors. However, if the coherence length of the superconductor is small, the local magnetic field intensity in the vortex will be very large, and magnetic atom flux pinning can be used to provide high critical currents. For magnetic pinning to work in such type II superconductors, the coherence length should be of the order of the atomic dimensions of the superconductor. That is, it should be approximately the length of the unit cell of the superconductor, and typically about 0,3 to 3 nanometers.

The inclusion of magnetic pinning atoms in high-$T_c$ superconductors can also introduce disorder in the planes that carry supercurrents, thereby decreasing the coherence length and increasing the magnetic field in the vortices. This will also aid in pinning vortices.

The figure illustrates a representative superconducting material in which magnetic flux pinning is used to enhance critical current. The superconductor 10 is contacted by electrodes 12A and 12B, which are in turn connected to a variable resistor R and a current source 14. Magnetic flux pinning sites are indicated by the randomly distributed dots 16. When the superconductor 10 is lowered to a temperature at which superconductivity occurs and a current is applied, the critical current $I_c$ will be enhanced by the presence of a compositionally random distribution of atoms having magnetic moments, where the number of these magnetic atoms is sufficient to pin substantial numbers of the flux vortices in the superconductor 10. Although shown in a schematic form in the figure, it should be understood by those of skill in the art that the superconductor 10 can be in bulk form or film form and can be a single crystal or polycrystalline material. Further, although the means for cooling the superconductor 10 are not shown in this diagram, cooling means are well known in the art. For a high-$T_c$ oxide superconductor, such as $YBa_2Cu_3O_x$, liquid nitrogen cooling is suitable while, for a type II superconductor having a critical transition temperature of less than 77 K, liquid helium cooling is used.

The magnetic atoms suitable for vortex pinning are easily incorporated into either bulk materials or film materials. For example, if a high-$T_c$ bulk superconductor comprising a rare earth or rare earth-like element, an alkaline earth element, copper and oxygen is to be fabricated, a powder containing the magnetic atoms is included with the powders that are mixed and later heated to form the bulk superconductor. In the specific example where a Y-Ba-Cu-O oxide superconductor is desired, the starting ingredients can include a powder of a magnetic element, such as a powder of a Gd oxide. The Gd atoms are likely to go onto the Y sites of the material to produce Gd-substituted Y-Ba-Cu-O oxide superconductors. Generally, magnetic rare earth atoms prefer to go on the rare earth sites, if the magnetic atoms tend to have a 3+ valence, and will tend to go on the alkaline earth sites to replace the Ba, if the magnetic rare earths tend to have a 2+ valence. Those of skill in the art will readily appreciate the known techniques for incorporating magnetic atoms in these high-$T_c$ bulk superconductors.

The inclusion of a magnetic atom in a film of high-$T_c$ oxide material is also very readily achieved. For example, a $YBa_cCu_3O_x$ thin film deposited epitaxially onto a $SrTiO_3$ substrate can be treated to incorporate magnetic atoms in the superconducting $YBa_cCu_3O_x$ film. To achieve this, the film/substrate combination is heated to dissolve a portion of the substrate into the superconductor film. This introduces Ti atoms which can enter the superconductor film on either the Y sites or the Ba sites, as well as on the $Cu^{2+}$ sites. The Ti atoms will be randomly distributed in the superconductor film and, if there are sufficient numbers of these Ti atoms, substantial flux pinning will occur to make the superconducting film exhibit a high critical current, even at temperatures approaching the superconducting transition temperature.

As an example of a fabrication process for producing magnetic flux pinning in a $YBa_2Cu_3O_x$ film epitaxially deposited on $SrTiO_3$, a post-deposition flash annealing of 1 to 2 seconds at a temperature of approximately 950°C can be utilized. After this, annealing for a few minutes at approximately 925°C is done to equilibrate the structure. This is followed by cooling in the furnace to absorb the right amount of oxygen to get a high-temperature superconductivity transition.

As an alternative to the introduction of atoms having a magnetic moment from a substrate, it is of course possible to introduce magnetic atoms during the deposition process. For example, for the deposition of a film of $YBa_2Cu_3O_x$, the technique of R.B. Laibowitz described in Phys. Rev. B 35 (1987) p. 8821, can be used in which an evaporation source comprised of the magnetic atoms would be incorporated. For example, in this technique for fabricating superconducting films, the various metals comprising the superconductor film to be deposited are sputtered or evaporated in an oxygen atmosphere to a substrate. An additional source would be included for the magnetic atoms. Depending upon the electron beam energy delivered to these sources and the amount of time for evaporation of the separate metals, the magnetic atoms would be directly incorporated into the deposited superconducting film.

The mechanism of magnetic vortex pinning and the equations used to determine the number of magnetic ions required to provide substantial vortex pinning and, therefore, enhanced critical current are now going to be described. In particular, the calculations are done with respect to high-$T_c$ oxide superconductors, and specifically the well known material $Y_1Ba_2Cu_3O_x$. However, the principles evaluated herein are applicable to other type II superconductors having very small coherence lengths of the sizes indicated previously.

If the source of pinning is distributed randomly, i.e. not every vortex is pinned, the effective pinning force per vortex is reduced. This is shown simply for the case of an array in which the vortices interact such that $F_{ij} = -F_{ji}$, where $F_{ij}$ is the force on the $i^{th}$ vortex due to the $J^{th}$ vortex. If the current exerts a force $F_i$ and the $K^{th}$ vortex is pinned by a force $F_{p,k}$, then

$$\sum_{J=1}^{N} F_{ij} + F_i = F_{p,k} \qquad (1)$$

Summing with respect to i yields

$$\sum_{C=1}^{N} F_i \doteq NF_i = \sum_k F_{p,k} \qquad (2)$$

if the current distribution is uniform. If only a fraction of the vortices are pinned, the resultant pinning of the array is reduced by that fraction. To get the full effect of pinning it would, therefore, be desirable to pin every vortex with the maximum pinning possible. The lattice parameter of an Abrikson lattice is approximately equal to 1,075 $(\Phi/B)^{1/2}$, where $\Phi$ is the flux quantum and B the magnetic field inside the superconductor. Setting B equal to $H_{c1}$, the average spacing between vortices is of the order of 30 nm and decreases with increasing field.

One of the remarkable properties of high-$T_c$ superconductors is their short coherence length. The intensity of the magnetic field inside the core of these superconductors is, therefore, high and, in fact, is comparable to but smaller than that associated with the molecular field in a ferromagnet. If magnetic ions are present in a core, there is a resultant interaction which lowers the core energy by an amount $(\Phi NgJ\mu_B B(x))/2\pi$, where N is the number of magnetic ions per unit volume, gJ the moment per ion, $\mu_B$ the Bohr magneton and B(x) the Brillouin function of the argument $x=(2gJ\mu_B H_{c2}/kT)$, where k is the Boltzmann constant and T the temperature. This energy is typically a few percent of the normal core energy if a few magnetic impurities per unit cell are assumed with the moment gJ equal to one. Clearly, it can become a significant fraction with enough magnetic ions having a large moment. This suggests that the $H_{c1}$ of these materials can be lowered by adding magnetic ions.

It is assumed that a vortex is flexible and pinned by fluctuations in the number of magnetic atoms it intersects. These fluctuations arise from a random distribution of atoms. If the magnetic moment were distributed at atomic sites in an ordered array there would be no pinning, regardless of the magnitude of the moment per site. The relevant scale over which fluctuations are important is set by the coherence length. The smaller this quantity, the larger the value of the fluctuation. The following is an approximate solution for the critical current using this argument.

The number of magnetic atoms per volume V of unit cell is given by N, and each atom has a moment gJ. For simplicity, it is assumed that only a single type of moment contributes to pinning. The number $N_p$ of magnetically active atoms in a volume defined by the coherence length $\xi$ is $\alpha 4\pi\xi^3/3V$. If the deviation from the average value $N_p$ is small, it can be represented by a normal distribution, and the volume V of material in which the probability of finding one fluctuation is unity is then given by

$$V \simeq (\pi/e^{-1/\pi})(\alpha 4\pi\xi^3/3V)(4\pi\xi^3/3) \qquad (3)$$

The average spacing, $\ell$, between such fluctuations is $V^{1/3}$. Assuming that the fluctuation in the number of atoms in the volume defined by the coherence length is given by $N_p^{1/2}$, the pinning energy is $(2H_{c2}gJ\mu_\beta B(x))\sqrt{N_p}$, and the average force required to depin the vortex is this value divided by $\ell$. Equating this to the force on the vortex exerted by a critical current density $J_c$, the following expression is obtained:

$$J_c\Phi_o\ell = (2H_{c2}gJ\mu_\beta B(x))\ell^{-1}N_p^{1/2} \qquad (4)$$

or

$$J_c(A/cm^2) = 3.37 \times 10^{-21} \left(\frac{\alpha}{V}\right)^{-1/6} (gJB(x))\xi^{-9/2} \quad (5)$$

In the $Y_1Ba_2Cu_3O_x$ compounds (termed the 1-2-3 compounds), the magnetic moment is associated with the $Cu^{2+}$ ions. Randomness in distribution arises from the presence of some $Cu^{3+}$ ions. Therefore, the following values are set: $gJ = 1$ and $\alpha = 1/2$. The latter value corresponds to the number of carriers which are generally believed to be associated with the $Cu^{3+}$ state. The coherence length at low temperature is about 3 nanometers. Substituting these values into Eq (5) yields for $J_c$ a value between $2 \times 10^5$ and $10^6 A/cm^2$ for $\xi = 2$ to 3 nm. The calculated critical current is in qualitative accord with the experimental observations.

The temperature dependence of the critical current comes not only from the dependence of the coherence length on temperature, but also from the Brillouin function. Near the transition temperature $T_c$ the argument of the Brillouin function is less than unity and, using the "dirty-limit-approximation" for the temperature dependence of the coherence length, the following expression is obtained for $J_c$:

$$J_c(A/cm^2) \approx 1.13 \times 10^{-20}(gJB(x))h^{-1}\xi^{-3} \quad (6)$$

for very thin films where h is the film thickness.

However, for most of the temperature range the Brillouin function cannot be approximated. Hence, the full expression is used and, using well known parameters, the temperature of the critical current can be calculated. This value has been compared with single crystal data, and the agreement is quite good.

Consider superconducting epitaxial films of $YBa_2Cu_3O_x$ on $SrTiO_3$. During the annealing of the superconducting compound the $SrTiO_3$ dissolves in the 1-2-3 compound. Both Sr and Ti atoms are introduced into the superconductor. Although the exact locations of these atoms in the superconductor are not known, it is reasonable to assume that the titanium is present either as $Ti^{2+}$ or $Ti^{3+}$. In either case, it carries a magnetic moment which is at least twice as large as the $Cu^{2+}$ moment. The Brillouin function approaches unity at much higher temperatures, so the temperature dependence is not as strong. A comparison with experimental data on an epitaxial film shows that the agreement is again good. This qualitative agreement lends support to the idea that vortex pinning by magnetic atoms distributed in a random fashion can be used to increase critical currents in these high temperature superconductors.

As noted, the proper incorporation of atoms having a magnetic moment can be used to successfully pin flux vortices in the superconducting materials, the temperature range over which substantial vortex pinning will occur being dependent on the magnitude of the magnetic moment per unit atom. The number of magnetic atoms required to be incorporated into the superconducting material is an amount sufficient to provide substantial vortex pinning (i.e., an amount which will increase $I_c$), and is such that a compositionally random distribution of the magnetic pinning atoms will be achieved. This means that 100% of the rare earth or alkaline earth atoms in, for example, high-$T_c$ oxide superconductors of the types well known in the art cannot be replaced, nor can the number of magnetic pinning atoms be so small that, even if they are randomly distributed, the number of vortices pinned would be too small to increase $I_c$. As noted, if approximately 50% of the atoms residing on the rare earth sites or atoms residing on the alkaline earth sites are replaced by atoms having a magnetic moment, a substantial number of the vortices will be pinned, and enhanced critical currents will be achieved. For a more complete analysis of the number of magnetic atoms providing a random distribution and, therefore, vortex pinning, reference is made to the previous equations, and particularly Eq. 5.

In the practice of this invention, type II superconductors having small coherence lengths of the order of the unit cell in the superconductor have been modified by the inclusion of atoms providing magnetic pinning sites for the flux vortices. These magnetic pinning sites must be randomly distributed in the superconductor to produce a compositionally random material. Also, they must be present in an amount sufficient to provide the required randomness and at the same time be sufficient in number to provide substantial vortex pinning. Of course, any amount of vortex pinning will help increase $I_c$, but the greater the number of vortices that are pinned, the greater the magnitude of $I_c$.

Vortex pinning has to be accomplished without seriously degrading the superconducting properties of the material. For example, if the superconductor is substantially degraded, the temperature range over which superconductivity is achieved will be affected and, even though it may exhibit high critical currents, the material will not be particularly useful unless the temperature range of superconductivity is easily achieved and maintained. Those of skill in the art will appreciate these design considerations, which will vary depending on the application in which the superconducting material is used.

While the invention has been described with respect to particular embodiments thereof, it will be appreciated by those of skill in the art that variations can be made therein without departing from the spirit and scope of the present invention. In this regard, more than one atomic species exhibiting a magnetic moment can be introduced into the superconductor, and the magnitude of the magnetic moment of these atoms can vary from small to large amounts. Of course, more effective pinning over a wider temperature range is provided when the atoms have large magnetic moments. On the other hand, atoms having very large magnetic moments that tend to occupy sites responsible for superconductivity, will possibly cause a loss of superconductivity within the material.

Further, while particular techniques have been illustrated for the incorporation of atoms having a magnetic moment in order to provide magnetic vortex pinning, those of skill in the art will realize that many variations can be utilized for incorporating the magnetic pinning atoms, whether film or bulk materials are utilized. Also, the general concept is the provision of magnetic pinning forces randomly distributed to provide increased $I_c$. Still further it will be realized by those of skill in the art that this invention applies to superconductors which are polycrystalline or single crystals, and which are fabricated in any geometry or form (plate, wire, etc.).

In particular, this technique can be used to produce high-$T_c$ oxide superconductors and apparatus, and specifically copper oxide superconductors having a $T_c$ greater than 77 K, which exhibit critical currents in excess of $10^4 A/cm^2$ at 77 K.

## Claims

1. Type-II superconductor with a short coherence length of the order of magnitude of the atomic dimensions in said superconductor and having vortices therein which, if free to move, can limit the maximum critical current through said superconductor, said superconductor including pinning sites for magnetically pinning said vortices to prevent their movement in said superconductor, said pinning sites being regular lattice sites occupied in a random fashion due to a partial substitution by atoms having magnetic moments associated therewith of sufficient magnitude to pin said vortices, *characterized* in that said coherence length is in the approximate range of 0,3 to 3 nm, that about 50% of the lattice sites of a component of said superconductor are occupied by atoms having magnetic moments greater than that of $Cu^{2+}$ atoms, such that the critical current $I_c$ of said superconductor is increased to a value greater than $10^4$ A/cm$^2$ at 77 K.

2. Superconductor in accordance with claim 1, *characterized* in that said superconductor is a bulk superconductor.

3. Superconductor in accordance with claim 1, *characterized* in that said superconductor is a film.

4. Superconductor in accordance with claim 1, *characterized* in that said superconductor is a high-$T_c$ superconductor exhibiting superconductivity at temperatures in excess of 26K, said superconductor including a rare earth and/or a rare earth-like element, an alkaline earth element, a transition metal element, and oxygen.

5. Superconductor in accordance with claim 4, *characterized* in that said atoms having magnetic moments reside on rare earth or rare earth-like sites in the lattice of said superconductor.

6. Superconductor in accordance with claim 4, *characterized* in that said atoms having magnetic moments reside on alkaline earth sites in the lattice of said superconductor.

7. Superconductor in accordance with claim 4, *characterized* in that said atoms having magnetic moments reside on transition metal sites in the lattice of said superconductor.

8. Superconductor in accordance with claim 1, *characterized* in that said atoms having magnetic moments are rare earth atoms.

9. Superconductor in accordance with claim 1, *characterized* in that said atoms having magnetic moments are transition metal atoms.

10. Superconductor in accordance with claim 4, *characterized* in that it has an orthorhombic structure.

11. Superconductor in accordance with claim 4, *characterized* in that it has a layered crystalline structure.

12. Superconductor in accordance with claim 4, *characterized* in that said superconductor is a Y-Ba-Cu-O compound.

13. Superconductor in accordance with claim 12, *characterized* in that said superconductor has a nominal

composition $YBa_2Cu_3O_x$.

## Patentansprüche

1. Supraleiter vom Typ II mit kurzer Kohärenzlänge in der Größenordnung der Atomabmessungen in diesem Supraleiter, in dem Wirbel auftreten, die bei freier Beweglichkeit den maximalen kritischen Strom durch den Supraleiter einschränken, wobei dieser Supraleiter Fixierungsstellen zum magnetischen Fixieren dieser Wirbel aufweist, um deren Beweglichkeit im Supraleiter zu verhindern, wobei diese Fixierungsstellen reguläre Gitterstellen sind, die in Zufallsverteilung infolge einer Teilsubstitution durch Atome mit ihnen zugeordneten magnetischen Momenten hinreichender Größe zwecks Fixierens dieser Wirbel besetzt sind, dadurch gekennzeichnet, daß diese Kohärenzlänge im angenäherten Bereich 0,3 bis 3 nm liegt, daß etwa 50% der Gitterstellen eines Bestandteils dieses Supraleiters von Atomen mit magnetischen Momenten besetzt sind, die größer sind als das von $Cu^{2+}$-Atomen, so daß der kritische Strom $I_c$ des Supraleiters erhöht wird und einen größeren Wert als $10^4 A/cm^2$ bei 77 K aufweist.

2. Supraleiter gemäß Anspruch 1, dadurch gekennzeichnet, daß der Supraleiter ein massiver Supraleiter ist.

3. Supraleiter gemäß Anspruch 1, dadurch gekennzeichnet, daß der Supraleiter eine Folie ist.

4. Supraleiter gemäß Anspruch 1, dadurch gekennzeichnet, daß der Supraleiter ein Hoch-$T_c$-Supraleiter ist, der Supraleitfähigkeit bei Temperaturen über 26 K aufweist, wobei der Supraleiter eine seltene Erde und/oder ein Seltenerdeelement, ein Alkalierdeelement, ein Übergangsmetallelement und Sauerstoff einschließt.

5. Supraleiter gemäß Anspruch 4, dadurch gekennzeichnet, daß diese Atome mit den magnetischen Momenten an den Stellen der seltenen Erden bzw. an den Stellen der seltenerdenähnlichen Elemente im Gitter des Supraleiters sitzen.

6. Supraleiter gemäß Anspruch 4, dadurch gekennzeichnet, daß diese Atome mit den magnetischen Momenten an den Stellen der alkalischen Erden im Gitter des Supraleiters sitzen.

7. Supraleiter gemäß Anspruch 4, dadurch gekennzeichnet, daß diese Atome mit den magnetischen Momenten an den Übergangsmetallstellen im Gitter des Supraleiters sitzen.

8. Supraleiter gemäß Anspruch 1, dadurch gekennzeichnet, daß diese Atome mit den magnetischen Momenten Seltenerdeatome sind.

9. Supraleiter gemäß Anspruch 1, dadurch gekennzeichnet, daß diese Atome mit den magnetischen Momenten Übergangsmetallatome sind.

10. Supraleiter gemäß Anspruch 4, dadurch gekennzeichnet, daß er eine rhombische Struktur aufweist.

11. Supraleiter gemäß Anspruch 4, dadurch gekennzeichnet, daß er eine geschichtete kristalline Struktur aufweist.

12. Supraleiter gemäß Anspruch 4, dadurch gekennzeichnet, daß der Supraleiter eine Y-Ba-Cu-O-Verbindung ist.

13. Supraleiter gemäß Anspruch 12, dadurch gekennzeichnet, daß der Supraleiter eine nominelle Zusammensetzung $YBa_2Cu_3O_x$ hat.

## Revendications

1. Superconducteur de type II présentant une courte longueur de cohérence de l'ordre de grandeur des dimensions atomiques dans ledit superconducteur et à tourbillons internes qui, s'ils sont libres de leur mouvement, peuvent limiter le courant critique maximal dans ledit superconducteur, ledit superconducteur comprenant des emplacements d'épinglage pour épingler magnétiquement lesdits tourbillons afin d'empêcher leur mouvement dans ledit superconducteur, lesdits emplacements d'épinglage étant des emplacements maillés réguliers occupés d'une manière aléatoire en raison d'une substitution partielle par des atomes dont les moments magnétiques associés sont de grandeur suffisante pour épingler lesdits tourbillons, caractérisé en ce que ladite longueur de cohérence est de l'ordre de 0,3 à 3 nm, en ce que à peu près 50% des emplacements maillés d'un composant dudit superconducteur, sont occupés par des atomes dont les moments magnétiques sont supérieurs à celui des atomes de $Cu^{2+}$, de façon que le courant critique $I_c$ dudit superconducteur soit élevé à une valeur supérieure à $10^4$ A/cm$^2$ à 77K.

2. Superconducteur selon la revendication 1, caractérisé en ce que ledit superconducteur est un superconducteur massif.

3. Superconducteur selon la revendication 1, caractérisé en ce que ledit superconducteur est un film.

4. Superconducteur selon la revendication 1, caractérisé en ce que ledit superconducteur est un superconducteur à $T_c$ de valeur élevée présentant une superconductivité à des températures au dessus de 26 K, ledit superconducteur comprenant une terre rare et/ou un élément comme de la terre rare, un élément de terre alcaline, un élément de métal de transition et de l'oxygène.

5. Superconducteur selon la revendication 4, caractérisé en ce que lesdits atomes à moments magnétiques se trouvent sur des emplacements de terre rare ou d'un élément comme de la terre rare dans la maille dudit superconducteur.

6. Superconducteur selon la revendication 4, caractérisé en ce que lesdits atomes à moments magnétiques se trouvent sur des emplacements de terre alcaline dans la maille dudit superconducteur.

7. Superconducteur selon la revendication 4, caractérisé en ce que lesdits atomes à moments magnétiques se trouve sur des emplacements de métal de transition dans la maille dudit superconducteur.

8. Superconducteur selon la revendication 1, caractérisé en ce que lesdits atomes à moments magnétiques sont des atomes de terre rare.

9. Superconducteur selon la revendication 1, caractérisé en ce que lesdits atomes à moments magnétiques sont des atomes de métal de transition.

10. Superconducteur selon la revendication 4, caractérisé en ce qu'il présente une structure orthorhombique.

11. Superconducteur selon la revendication 4, caractérisé en ce qu'il présente une structure cristalline en couches.

12. Superconducteur selon la revendication 4, caractérisé en ce que ledit superconducteur est un composé de Y-Ba-Cu-O.

13. Superconducteur selon la revendication 12, caractérisé en ce que ledit superconducteur a une composition nominale de $YBa_2Cu_3O_x$.